# EUROPEAN PATENT APPLICATION

(11) **EP 4 845 319 A1**
(43) Date of publication of application: **25.11.2026**
(21) Application number: 25177892.4
(22) Date of filing: 21.05.2025
(51) Int. Cl.: H05K 7/14

(54) **POWER ELECTRONICS BUILDING BLOCK, CONVERTER WITH POWER ELECTRONICS BUILDING BLOCK, METHOD FOR DEMOUNTING A POWER ELECTRONICS BUILDING BLOCK FROM A RACK OF A CONVERTER, METHOD FOR MOUNTING A POWER ELECTRONICS BUILDING BLOCK TO A RACK OF A CONVERTER AND METHOD FOR SWAPPING A POWER ELECTRONICS BUILDING BLOCK OF A CONVERTER**

(71) Applicant: Hitachi Energy Ltd, 8050 Zürich (CH)
(72) Inventor: Lutz, Pascal, 5432 Neuenhof (CH); Luzina, Maximilian, 85521 Ottobrunn (DE)
(74) Representative: Epping - Hermann - Fischer

(57) **Abstract**

Power electronics building block, converter with power electronics building block, method for demounting a power electronics building block from a rack of a converter, method for mounting a power electronics building block to a rack of a converter and method for swapping a power electronics building block of a converter

A power electronics building block, is described that is configured to be mounted to a converter. A power electronics building block is a functional unit that can be configured to perform specific power conversion, control or regulation tasks within a larger electrical system. The power electronics building block comprises a device configured to automatically short circuit the power electronics building block in a demounted state in which the power electronics building block is demounted from the converter. Furthermore, a converter with a power electronics building block, a method for demounting a power electronics building block from a rack of a converter, a method for mounting a power electronics building block to a rack of a converter and a method for swapping a power electronics building block of a converter are described.

## Description

Power electronics building block, converter with power electronics building block, method for demounting a power electronics building block from a rack of a converter, method for mounting a power electronics building block to a rack of a converter and method for swapping a power electronics building block of a converter
The present disclosure relates to a power electronics building block, a converter with a power electronics building block, a method for demounting a power electronics building block from a rack of a converter, a method for mounting a power electronics building block to a rack of a converter and a method for swapping a power electronics building block of a converter.

It is desirable to provide a power electronics building block with improved electric characteristics.

In the following, a power electronics building block is described. In the dependent claims, embodiments of features are provided which may provide additional advantages. Furthermore, a converter with a power electronics building block, a method for demounting a power electronics building block from a rack of a converter, a method for mounting a power electronics building block to a rack of a converter and a method for swapping a power electronics building block of a converter are described.

A power electronics building block, in the following PEBB, is described that is configured to be mounted to a converter. A PEBB is a functional unit that can be configured to perform specific power conversion, control or regulation tasks within a larger electrical system. The power electronics building block comprises a device configured to automatically short circuit the power electronics building block in a demounted state in which the power electronics building block is demounted from the converter.

The device of the PEBB according to the invention automatically short circuits the PEBB. The short circuiting of the PEBB in a demounted state is necessary, as in a demounted state, the PEBB is not connected to a grounding. If the PEBB is not short circuited and not connected to a grounding, the PEBB can build up a charge, increasing the risk of defects of the PEBB and increasing safety risks. An operator demounting a PEBB from a rack of a converter does therefore not have to manually close the short circuit of the PEBB which increases safety and efficiency of this demounting process and reduces the complexity and duration of the maintenance process. Furthermore, as the PEBB is short circuited automatically, the step of short circuiting the PEBB cannot be overlooked by the operator demounting the PEBB, as the manual step of closing the short circuit is omitted.

According to an embodiment, the device is further configured to automatically open the short circuit in a mounted state in which the PEBB is mounted to the converter. An operator mounting a PEBB to a rack of a converter does therefore not have to manually open the short circuit of the PEBB before mounting the PEBB which increases safety and efficiency of this mounting process.

According to an embodiment, the PEBB comprises two terminals, for example one DC+ and one DC- terminal, and the device comprises a spring-loaded short circuit bar that is configured to connect the two terminals of the PEBB in the demounted state. The spring-loaded circuit bar can for example comprise a spring and an electrically conductive bar, the electrically conductive bar can for example be connected to one of the terminals, and be pushed by the spring onto the second terminal. By connecting the two terminals of the PEBB, the spring-loaded short circuit bar short circuits the PEBB, providing the above-mentioned advantages of a short circuited PEBB.

According to an embodiment, the spring-loaded short circuit bar is configured to be disconnected from at least one of the terminals of the PEBB in the mounted state. The electrically conductive bar can for example be pushed away from one of the terminals of the PEBB by a mechanism of the converter when being mounted to a rack. This opens the short circuit of the PEBB. In this mounted state, the spring is compressed, therefore acting a pretension onto the electrically conductive bar. Upon removal of the PEBB from the rack of the converter, this pretension pushes the electrically conductive bar back towards the terminal, the electrically conductive bar therefore connecting both terminals and short circuiting the PEBB.

According to an embodiment, the PEBB comprises an adapter that comprises a DC+ terminal and a DC- terminal that are configured to enable an electrical contact to the PEBB. The adapter further comprises a spring-loaded circuit bar, the spring-loaded circuit bar comprising an electrically conductive bar configured to connect the DC+ terminal and the DC- terminal in a demounted state of the PEBB and a spring providing a pretension that pushes the electrically conductive bar against the terminals in a demounted state of the PEBB. In this embodiment, the PEBB further comprises a DC+ busbar and a DC- busbar that connect the DC+ and DC- terminals to a capacitor. The busbars further connect the capacitor to a semiconductor module that is placed on a heat sink. The semiconductor module is connected to a busbar of the PEBB that is configured to connect multiple PEBBs to each other. This enables the option to connect multiple PEBBs in series.

A converter is described which comprises a PEBB as described above and a rack. The rack is configured for mounting the PEBB and comprises a mechanism that is configured to interact with the device of the PEBB for opening and closing the short circuit in the PEBB.

According to an embodiment, the converter comprises two or more PEBBs. This enables the converter to increase the amount of energy that can be stored. The PEBBs may comprise different potentials. The PEBBs may be connected in series. By connecting multiple PEBBs in series, higher voltages of the converter can be achieved.

According to an embodiment, the two or more PEBBs are mounted in the rack above each other in a stacking direction, for example in a tower-like structure. Like this, the base area required for storing multiple PEBBs is reduced.

According to an embodiment, two or more PEBBs are mounted in the rack next to each other. The PEBBs can for example be mounted above each other and next to each other in a matrix-like pattern. Like this, more PEBBs can be mounted to the same rack.

According to an embodiment, the PEBB comprises a modular design. This enables the PEBB to be replaced in case of a defect by another PEBB with the same modular design. This further enables the PEBBs to be placed at an arbitrary mounting slot in the rack, as every mounting slot in the rack comprises the same mounting conditions. The modular design reduces the risk of incorrectly mounting a PEBB to a rack, as every PEBB fits to every mounting slot in the rack. It furthermore reduces the complexity of assembling and servicing the converter, the number of different components used, the required time to assemble and service the converter and therefore the costs of the converter itself and its maintenance.

According to an embodiment, the PEBB is mounted to the rack in a mounting direction. The PEBB may be mounted by simply being pushed into a matching mounting slot on the rack in the mounting direction.

According to an embodiment, the mounting slots of the rack comprise a modular design. Therefore, each of the mounting slots provides the same mounting conditions for a PEBB. This enables the possibility to mount PEBBs with a modular design to arbitrary mounting slots in the rack, enabling the above-mentioned advantages of a modular design of the PEBBs.

According to an embodiment, the rack comprises a fast connector to each PEBB. The fast connector enables an electrical connection to the terminals of the PEBB.

According to an embodiment, the rack comprises a separate access point for each PEBB for measuring the cell voltages of each separate PEBB. This enables an operator to detect PEBBs comprising a residual voltage. The operator can then manually discharge these PEBBs via the respective access point. By grounding the access point, for example by connecting a grounding device to the access point, the respective PEBB is grounded as well. This increases the safety of the converter.

According to an embodiment, the access points may be placed at the bottom of the rack, allowing an operator to measure the PEBB's cell voltages and to discharge the PEBBs without having to work at heights in order to reach the PEBBs at the top. This increases the safety of the process of measuring and discharging the PEBBs.

According to an embodiment, the access points of all PEBBs are positioned on the rack next to each other, increasing the efficiency of the process of measuring and discharging the PEBBs, as the operator measuring and discharging the PEBBs does not have to move from one access point to another placed at a different location on the rack.

According to an embodiment, each PEBB is configured to be separately discharged via its separate access point. The discharging process can for example be executed by using a portable discharge device that is connected to the access point of the PEBB to be demounted. This enables discharging the PEBB before demounting the PEBB from the rack and before short circuiting the PEBB, increasing the safety when storing the PEBB in a demounted state.

According to an embodiment, the mechanism of the converter comprises a separate insulated rod for each power electronics building block, the insulated rod being electrically nonconductive and being configured to engage with the device of the power electronics building block for opening and closing of the short circuit in the power electronics building block. The insulated rod can for example push the spring-loaded circuit bar of the PEBB away from at least one of the terminals when the PEBB is mounted to the rack, opening the short circuit of the PEBB. Upon removal of the PEBB from the rack, the PEBB is removed from the insulated rod. Consequently, the spring-loaded circuit bar is pushed back onto the terminals by its pretension, connects both terminals and therefore short circuits the PEBB.

A method for mounting a PEBB to and demounting a PEBB from the rack of a converter, as well as a method for swapping a PEBB of a converter are additionally provided. By means of the methods, a PEBB as indicated in connection with at least one of the above-stated embodiments is mounted to, demounted from, or swapped of a rack of a converter as indicated in connection with at least one of the above-stated embodiments. Features of the PEBB and the converter are therefore also disclosed for the methods and vice versa.

A method for demounting a PEBB as described above from a rack of a converter as described above comprises automatically short circuiting the PEBB while demounting the PEBB from the rack. This increases safety and efficiency and reduces the complexity and duration of the demounting process.

A method of mounting a PEBB as described above to a rack of a converter as described above comprises automatically opening a short circuit of the PEBB while mounting the PEBB to the rack. This increases reliability and efficiency and reduces the complexity and duration of the mounting process.

A method for swapping a PEBB as described above of a converter as described above comprises the method of demounting a PEBB from a rack of a converter and the method of mounting a PEBB to a rack of a converter. This increases efficiency, safety and reliability and reduces the complexity and duration of the swapping process.

A PEBB, a converter and methods for mounting, demounting or swapping a PEBB to, from or of a converter described herein are explained in greater detail below by way of exemplary embodiments with reference to the drawings. However, the invention is not limited to said exemplary embodiments. Further, said exemplary embodiments are depicted in figures showing schematic drawings. These schematic drawings are not true to scale, and absolute and relative dimensions can be depicted in a distorted manner. Accordingly, no absolute or relative dimensions can be taken from the schematic depictions unless otherwise indicated. Elements that are identical, similar or have the same effect are denoted by the same reference signs in the figures.
Figure 1 shows a schematic drawing of a converter according to an embodiment, the converter comprising a rack and four PEBBs.
Figure 2 shows a schematic cross-sectional view of a PEBB, the PEBB comprising four capacitors, an adapter, a DC+ and a DC- busbar, a semiconductor module and a busbar of the PEBB.
Figures 3a shows a detailed cross-sectional view of the adapter of the PEBB in a mounted state of the PEBB to a rack of a converter.
Figure 3b shows a detailed cross-sectional view of the adapter of the PEBB in a demounted state of the PEBB from a rack of a converter.
Figure 4a shows a schematic drawing of a converter comprising a rack, four PEBBs and access points for the terminals of the PEBBs.
Figure 4b shows a detailed view on the access points for the terminals of the PEBBs.

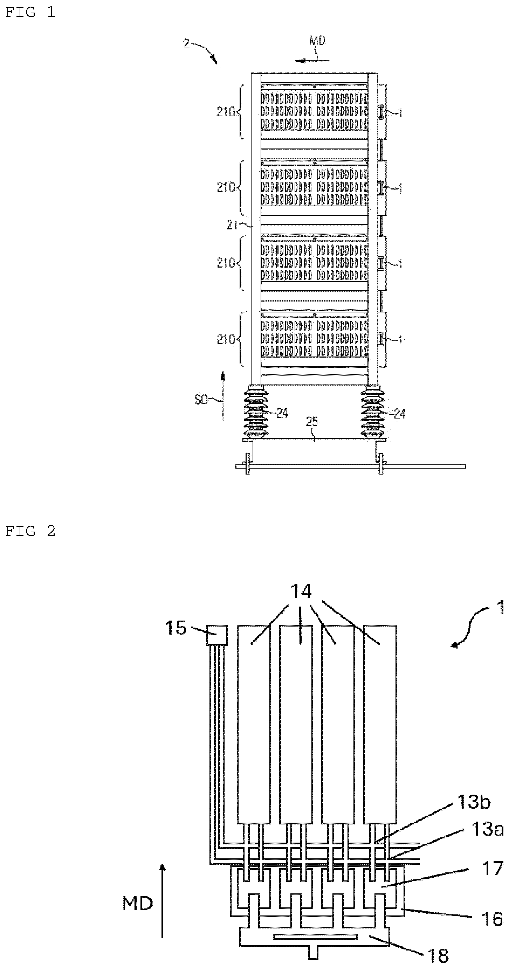

Figure 1 shows a first embodiment of a converter 2 comprising a rack 21 and four PEBBs 1. The four PEBBs 1 are only exemplary, the converter 2 may comprise any other number of PEBBs 1. The rack 21 provides a mounting slot 210 for each of the PEBBs 1. The PEBBs 1 are mounted to the rack 21 by being pushed into the mounting slot 210 in a mounting direction MD. The PEBBs 1 are mounted in the rack 21 above each other in a stacking direction SD. For example, the mounting direction MD and the stacking direction SD are perpendicular to each other. By mounting the PEBBs 1 above each other, the base area required for storing multiple PEBBs is reduced. However, the PEBBs 1 can also be mounted differently than above each other, for example next to each other or in a matrix-like pattern above each other and next to each other.

The rack 21 of the converter 2 furthermore comprises an insulator 24 that is placed at the bottom of the rack 21. The rack 21 is arranged on a base platform 25.

The PEBBs 1 comprise a modular design. Furthermore, the mounting slots 210 of the rack 21 comprise a modular design. Therefore, each of the PEBBs 1 is mountable to each of the mounting slots 210 provided by the rack 21. This simplifies the assembly and the maintenance of the converter 2 and enables the PEBBs 1 to be replaced by a PEBB 1 with the same modular design in case of defects.

Figure 2 shows a schematic cross-sectional view of a PEBB 1. The PEBB 1 comprises four capacitors 14 that are each configured to store electrical energy. The four capacitors 14 are only exemplary, the PEBB 1 may comprise any other number of capacitors 14. The capacitors 14 are electrically connected to a DC+ busbar 13a and a DC- busbar 13b. The busbars 13a, 13b electrically connect the capacitors 14 to four semiconductor modules 17 and to an adapter 15 of the PEBB **1.** The four semiconductor modules 17 are only exemplary, the PEBB 1 may comprise any other number of semiconductor modules 17.

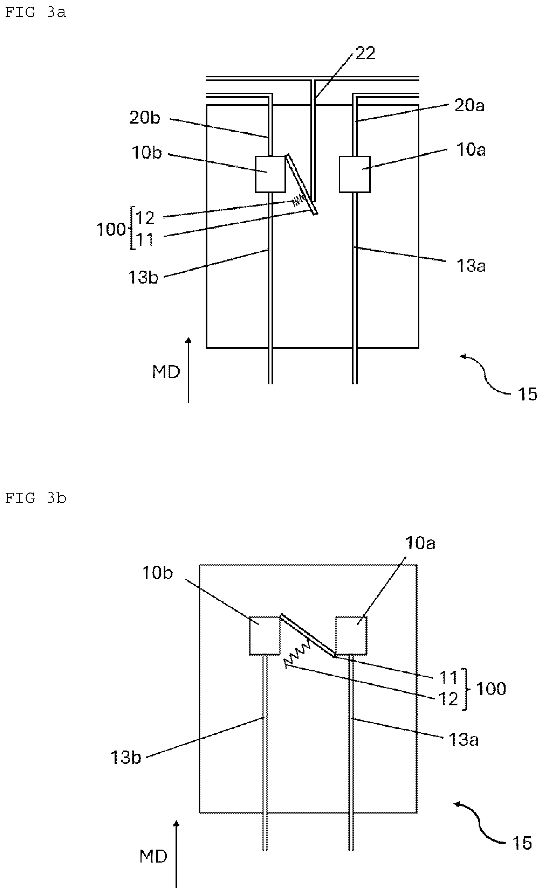

The adapter 15 is configured to enable a connection of the PEBB 1 to the rack 21 of the converter 2. Furthermore, the adapter 15 comprises a device that is configured to short circuit the PEBB 1 in a demounted state. A more detailed description of the adapter 15 can be found in the description of figures 3a and 3b.

The semiconductor modules 17 are placed on a heat sink 16. The semiconductor modules 17 are connected to a busbar 18 of the PEBB 1 that is configured to connect multiple PEBBs 1 to each other. This enables the option to connect multiple PEBBs 1 in series.

Figure 2 furthermore shows the mounting direction MD in which the PEBB 1 is mounted to the rack 21 of the converter 2.

Figures 3a and 3b show a detailed cross-sectional view of the adapter 15 of the PEBB 1 in a mounted state, see Fig. 3a, and in a demounted state, see Fig. 3b.

Both figures 3a and 3b show the adapter 15 comprising a DC+ terminal 10a and a DC- terminal 10b. The DC+ terminal 10a is connected to the DC+ busbar 13a, and the DC- terminal 10b is connected to the DC- busbar 13b. The terminals 10a, 10b are therefore connected to the capacitors 14 as explained in the description of figure 2.

The adapter 15 further comprises a spring-loaded short circuit bar 100 comprising a spring 12 and an electrically conductive bar 11.

The figures 3a and 3b furthermore show the mounting direction MD, in which the PEBB 1, and therefore the adapter 15, is mounted to a rack 21 of a converter 2.

Figure 3a shows the mounted state of a PEBB 1 to the rack 21 of the converter 2. The DC+ terminal 10a is electrically connected to a DC+ fast connector 20a, and the DC- terminal 10b is electrically connected to a DC- fast connector 20b. This enables an electrical connection to the PEBB 1. By electrically connecting the PEBB 1, the cell voltages of the PEBBs 1 can be measured, and PEBBs 1 with a residual voltage can be discharged at an access point 23a, 23b on the rack 21. By grounding the access point 23a, 23b, the respective mounted PEBB 1 is grounded as well.

In the mounted state, an insulated rod 22 of the rack 21, the insulated rod 22 being an electrically nonconductive rod, pushes the electrically conductive bar 11 that is connected to the DC- terminal 10b away from the DC+ terminal 10a, therefore opening the short circuit of the PEBB **1.** The spring 12 provides a pretension that pushes the electrically conductive bar 11 in a direction facing the DC+ terminal 10a against the insulated rod 22. When the PEBB 1 is demounted from the rack 21 in a direction opposite to the mounting direction MD, the spring 12 pushes the electrically conductive bar 11 towards the DC+ terminal 10a. Once the PEBB 1 is moved a certain distance in the direction opposite to the mounting direction MD, the electrically conductive bar 11 contacts the DC+ terminal 10a, automatically creating a short circuit inside the PEBB **1.** This can be seen in figure 3b.

In the demounted state, the electrically conductive bar 11 that is connected to the DC- terminal 10b is pushed against the DC+ terminal 10a, thus short circuiting the PEBB **1.** When the PEBB 1 is mounted to the rack 21 in the mounting direction MD, the insulated rod 22 pushes the electrically conductive bar 11 away from the DC+ terminal 10a and compresses the spring 12. Once the PEBB 1 is moved a certain distance in the mounting direction MD, the electrically conductive bar 11 no longer contacts the DC+ terminal 10a, automatically opening the short circuit inside the PEBB 1. Furthermore, the fast connectors 20a, 20b electrically contact the terminals 10a, 10b. This can be seen in figure 3a.

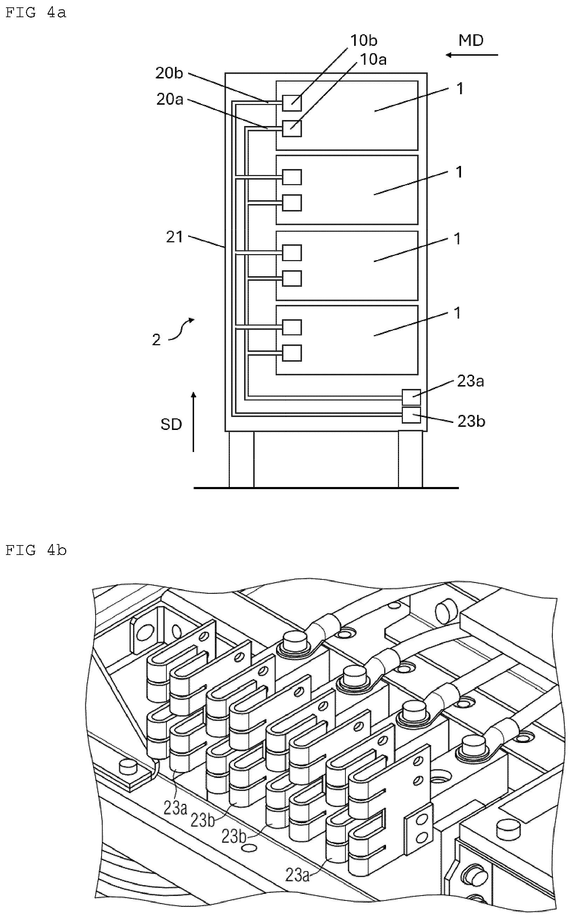

Figure 4a shows a schematic drawing of the converter 2 with a focus on the electrical connection between the four PEBBs 1 and the access points 23a, 23b.

The four PEBBs 1 are mounted to the rack 21 of the converter 2 in the mounting direction MD and are mounted in the rack 21 above each other in the stacking direction SD. The four PEBBs 1 are only exemplary, the converter 2 may comprise any other number of PEBBs 1. Furthermore, the PEBBs 1 may be mounted differently than above each other, for example next to each other or in a matrix-like pattern above each other and next to each other.

The PEBBs 1 are shown in a simplified version, the only details provided are the DC+ terminal 10a and the DC- terminal 10b. Each of the DC+ terminals 10a of the four PEBBs 1 is connected to its respective DC+ fast connector 20a. Each of the DC- terminals 10b of the four PEBBs 1 is connected to its respective DC- fast connector 20b.

Each DC+ fast connector 20a is electrically connected to a separate DC+ access point 23a. Each DC- fast connector 20b is electrically connected to a separate DC- access point 23b. For simplification, Fig. 4a only shows a schematic connection of the fast connectors 20a, 20b to a central access point, however, when regarding Fig. 4b, it is clear that every fast connector 20a, 20b is connected to a separate access point 23a, 23b.

All access points 23a, 23b are located at the bottom of the rack 21, enabling an easy access for an operator to the access points 23a, 23b.

The access points 23a, 23b enable an operator to measure the cell voltages of each separate PEBB 1. This enables the operator to measure the cell voltages of each of the PEBBs 1 and therefore to detect any PEBBs 1 with a residual voltage, increasing the reliability of the converter 2. Furthermore, the access points 23a, 23b enable an operator to separately discharge the PEBBs 1 before demounting them from the rack 21, increasing the safety of the demounting process and enabling a safe storage of the PEBBs 1.

Figure 4b shows a detailed view on the access points 23a, 23b. Every fast connector 20a, 20b is electrically connected to a corresponding access point 23a, 23b. All access points 23a, 23b of all PEBBs 1 are located at the bottom of the rack and in proximity to each other, allowing an operator to easily access the access points 23a, 23b.

### Reference Signs

- 1: Power electronics building block
- 10a: DC+ terminal
- 10b: DC- terminal
- 100: Spring-loaded short circuit bar
- 11: Electrically conductive bar
- 12: Spring
- 13a: DC+ busbar
- 13b: DC- busbar
- 14: Capacitor
- 15: Adapter
- 16: Heat sink
- 17: Semiconductor Module
- 18: Busbar of the power electronics building block
- 2: Converter
- 20a: DC+ fast connector
- 20b: DC- fast connector
- 21: Rack
- 210: Mounting slot
- 22: Insulated rod
- 23a: DC+ access point
- 23b: DC- access point
- 24: Insulator
- 25: Base platform
- SD: Stacking direction
- MD: Mounting direction

## Claims

1. Power electronics building block (1) configured to be mounted to a converter (2), the power electronics building block (1) comprising
a device configured to automatically short circuit the power electronics building block (1) in a demounted state in which the power electronics building block (1) is demounted from the converter (2).

2. Power electronics building block (1) according to the previous claim,
wherein the device is configured to automatically open the short circuit in a mounted state in which the power electronics building block (1) is mounted to the converter (2).

3. Power electronics building block (1) according to any of the previous claims,
wherein the power electronics building block (1) comprises two terminals (10a, 10b),
wherein the device comprises a spring-loaded short circuit bar (100), configured to connect the two terminals (10a, 10b) of the power electronics building block (1) in the demounted state for short circuiting the power electronics building block (1).

4. Power electronics building block (1) according to the previous claim,
wherein the spring-loaded short circuit bar (100) is configured to be disconnected from at least one of the terminals (10a, 10b) of the power electronics building block (1) in the mounted state for opening the short circuit of the power electronics building block (1).

5. Converter (2), comprising
a power electronics building block (1) according to any of the previous claims,
a rack (21) configured for mounting the power electronics building block (1),
the rack (21) comprising a mechanism configured to interact with the device of the power electronics building block (1) opening and closing of the short circuit in the power electronics building block (1).

6. Converter (2) according to the previous claim,
wherein the power electronics building block (1) comprises a modular design.

7. Converter (2) according to any of the previous claims 5 or 6,
wherein two or more of the power electronics building blocks (1) are mounted in the rack (21) above each other in a stacking direction (SD).

8. Converter (2) according to any of the previous claims 5 to 7,
wherein the rack (21) comprises a fast connector (20a, 20b) to each power electronics building block (1) for an electrical connection to the terminals (10a, 10b) of the power electronics building blocks (1).

9. Converter (2) according to any of the previous claims 5 to 8,
wherein the rack (21) comprises a separate access point (23a, 23b) for each power electronics building block (1) for measuring the cell voltages of each separate power electronics building block (1).

10. Converter (2) according to the previous claim,
wherein the access points (23a, 23b) of all power electronics building blocks (1) are positioned on the rack (21) next to each other.

11. Converter (2) according to any of the previous claims 9 or 10,
wherein each power electronics building block (1) is configured to be separately discharged via its separate access point (23a, 23b).

12. Converter (2) according to any of the previous claims 5 to 11,
wherein the mechanism comprises a separate insulated rod (22) for each power electronics building block (1), the insulated rod (22) being configured to engage with the device of the power electronics building block (1) for opening and closing of the short circuit in the power electronics building block (1).

13. Method for demounting a power electronics building block (1) from a rack (21) of a converter (2) according to any of the previous claims 5 to 12, the method comprising: automatically short circuiting the power electronics building block (1) while demounting the power electronics building block (1) from the rack (21).

14. Method for mounting a power electronics building block (1) to a rack (21) of a converter (2) according to any of the previous claims 5 to 12, the method comprising: automatically opening a short circuit of the power electronics building block (1) while mounting the power electronics building block (1) to the rack (21).

15. Method for swapping a power electronics building block (1) of a converter (2), the method comprising
- demounting a power electronics building block (1) from a rack (21) of a converter (2) according to the method of previous claim 13, and
- mounting a power electronics building block (1) to a rack (21) of a converter (2) according to the method of previous claim 14.
